# EUROPEAN PATENT APPLICATION

(11) **EP 2 521 190 A1**
(43) Date of publication of application: **07.11.2012**
(21) Application number: 12159827.0
(22) Date of filing: 16.03.2012
(51) Int. Cl.: H01L 31/18

(54) **System for realising connection lines between strings of cells in photovoltaic modules**

(30) Priority: 03.05.2011 IT PD20110137
(71) Applicant: 2BG S.r.l., 35018 San Martino di Lupari (PD) (IT)
(72) Inventor: Bernardi, Dario, I-35010 Carmignano Di Brenta, PADOVA (IT); Galiazzo, Antonio, I-35018 San Martino Di Lupari, PADOVA (IT); Guidolin, Javier, I-31050 Vedelago, TREVISO (IT)
(74) Representative: Mitola, Marco

(57) **Abstract**

The invention relates to a system for realising connection lines between strings of cells in photovoltaic modules. Such lines consists of conductor foils L welded to electric terminals T of the strings S. The system 1 comprises: - a support platform 2 for at least one photovoltaic module having the electric terminals bare: - at least one device 10 for positioning at least one foil L at one or more terminals, the positioning device comprising one or more releasable gripping elements 11 of the foil L; - at least one device 20 for welding the foil L to one or more electric terminals. The system being characterised by the fact that the positioning device comprises at least one screening plate for welding 12 positioned near the gripping elements. The plate and the gripping elements being movable in relation to each other between a first position, in which they are distanced from each other to create an aperture 13 for the insertion of the terminals, and a second position, in which they are brought closer together so as to reduce the opening of such aperture and allow contact of the foil (L) with one or more electric terminals T.

## Description

### Field of application

The present invention relates to a system for realising connection lines between strings of cells in photovoltaic modules.

### State of the art

In general, the production of a photovoltaic module envisages the following operating steps:

- electrically connecting individual photovoltaic cells in series to form strings;

- positioning several strings on a glass plate at a side of said plate covered with a film of adhesive polymer material (EVA);

- electrically interconnecting the strings at the ends to realise connection lines (buses) so as to form a photovoltaic module;

- completion of the module with the application of adhesive and protective sheets;

- lamination of the module;

- trimming of the edges of the module;

- attachment of the frames and of the box for the external electrical contacts;

- final testing.

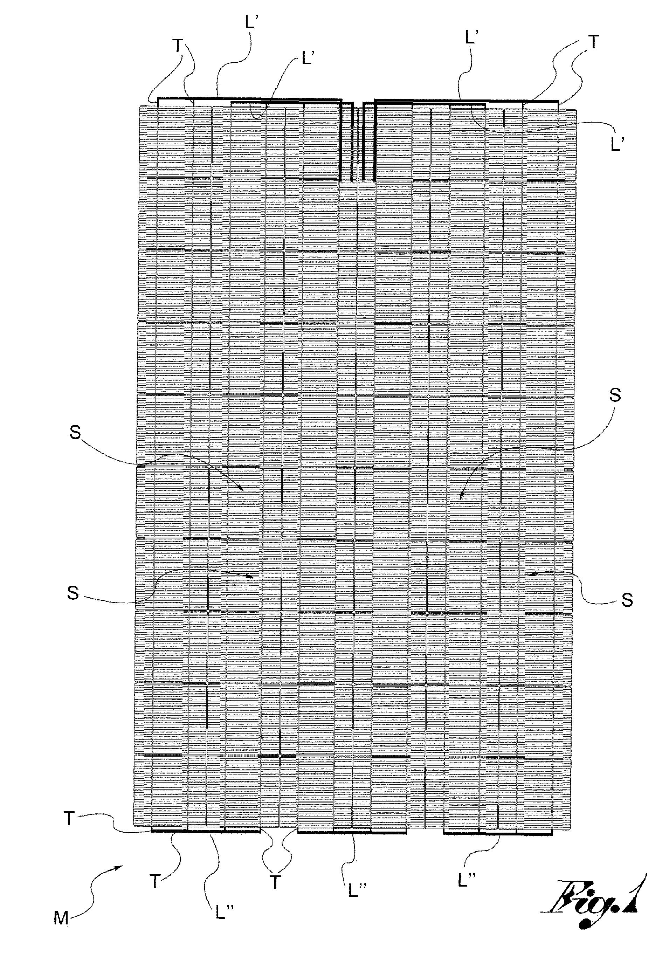

Figure 1 shows an example of a photovoltaic module M with connection lines L of the electric terminals T of the strings S already realised. In general the box for the external electrical contacts (not shown) is fixed near a first end of the module. The connection lines made at said first end (indicated by L') are suitably shaped (for example to form a 90° angle) to converge towards the box. The connection lines made at the other end (indicated by L") are instead linear, having to connect the terminals only.

The electrical interconnection of the strings is performed by welding the electric terminals at the end of each string to connection lines (buses), according to predefined electric schemes. The connection lines are composed of segments of metallic foils (ribbons), in particular tinned copper, similar to that used to interconnect the cells of a string.

The welding may be performed manually, for example by tinning, or automatically using current or laser induction methods.

The welding must not involve the layer of polymeric material (EVA) which the strings of cells are placed on. In fact, damage to the EVA layer which could prevent adequate insulation of the module being formed during the lamination step must be avoided.

To such purpose, a screening plate made in thermally insulating and resistant material (for example from epoxy glass or bakelite), is usually placed between the layer of polymeric material (EVA) and the electric terminals to be welded.

Such screening plate may be positioned manually or automatically using a manipulator device dedicated to such function.

The limitation of the known automised systems lies in the complexity of performing the positioning step of the protective plate in relation to the subsequent and separate step of positioning the connection ribbons at the terminals of the strings.

More specifically, the operating steps are as follows:

- Positioning of the protective plate at the terminals;

- Positioning of the connection ribbons at the terminals on the protective material;

- Welding of the connection ribbons to the terminals;

- Removal of the protective plate.

The complexity is linked essentially to the fact that the protective plate needs to be correctly positioned both during the positioning of the ribbons, and during the welding of the ribbons to the terminals.

### Presentation of the invention

Consequently, the purpose of the present invention is to overcome the drawbacks of the prior art mentioned above by making available a system for realising connection lines between strings of cells in photovoltaic modules which makes it possible to position both the protective screening plate and the connection ribbons in an operatively simpler and efficient manner.

A further purpose of the present invention is to make available a system for realising connection lines between strings of cells in photovoltaic modules which is mechanically reliable.

A further purpose of the present invention is to make available a system for realising connection lines between strings of cells in photovoltaic modules which as a whole makes the "bussing" of the strings of cells in photovoltaic modules more efficient and faster.

A further purpose of the present invention is to make available a system for realising connection lines between strings of cells in photovoltaic modules which is simple and economical to realise.

### Brief description of the drawings

The technical characteristics of the invention, according to the aforementioned purposes, are clearly evident from the contents of the following claims and the advantages of the same will be clearer from the detailed description which follows, made with reference to the appended drawings, showing one or more embodiments by way of non-limiting examples, wherein

:

- Figure 1 shows an example of a photovoltaic module with the connection lines of the terminals of the strings already realised;

- Figure 2 shows a perspective overall view of a system for realising connection lines between strings of cells in photovoltaic modules according to the invention, illustrated during a welding step;

- Figure 3 shows a plan view of the system illustrated in Figure 2;

- Figure 4 shows an enlarged perspective view of a detail of Figure 2 highlighted in the circle IV therein;

- Figure 5 shows a detail of the system in Figure 2, relative to a preparation station of the connection ribbons, illustrated during a step of taking the same ribbons;

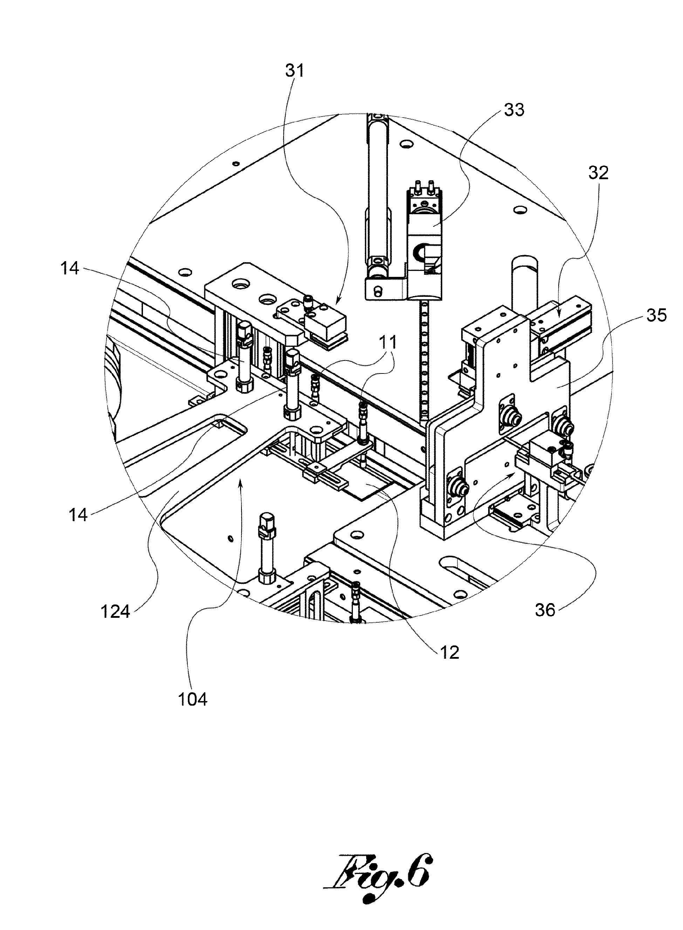

- Figure 6 shows an enlarged perspective view of a detail of Figure 5 highlighted in the circle VI therein;

- Figure 7 shows a plan view of the system illustrated in Figure 5;

- Figure 8 shows an enlarged perspective view of a detail of Figure 7 highlighted in the circle VIII therein;

- Figure 9 shows a perspective view of positioning means of segments of connection lines, according to a particular embodiment of the invention;

- Figures 10 and 11 respectively show a plan view and a side view of the positioning means in Figure 9;

- Figures 12a-b show schematically two steps of positioning a connection segment on a terminal of a string of a module, the proportions between the parts not being observed for illustrative purposes;

- Figure 13 shows a detail of the welding system in Figure 2, relative to a welding head according to a particular embodiment of the invention;

- Figure 14 shows an enlarged perspective view of the preparation station of the connection ribbons of the system for realising connection lines between strings of cells in photovoltaic modules illustrated in Figure 2;

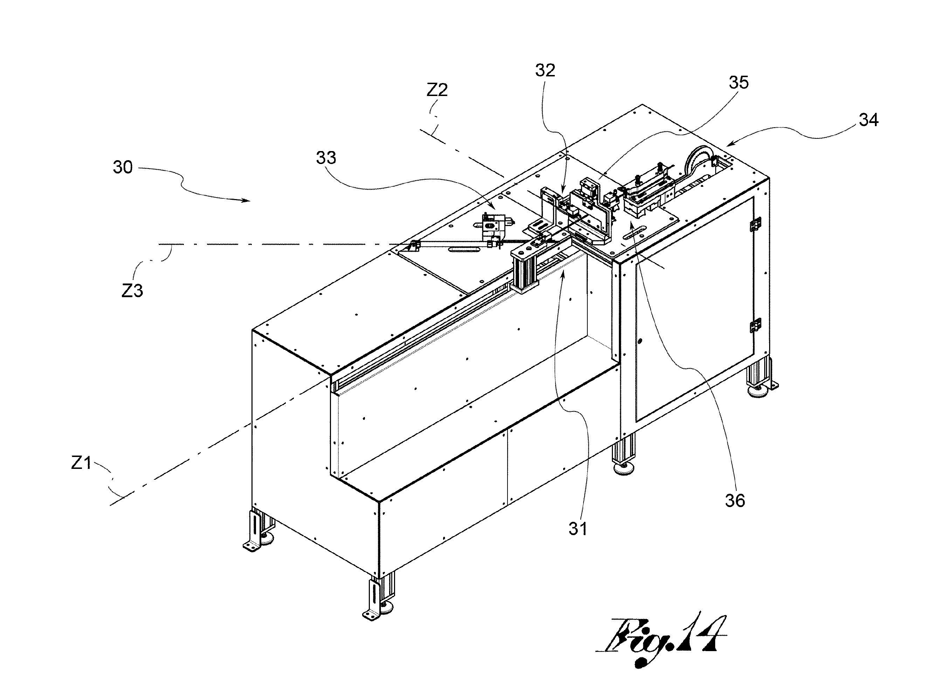

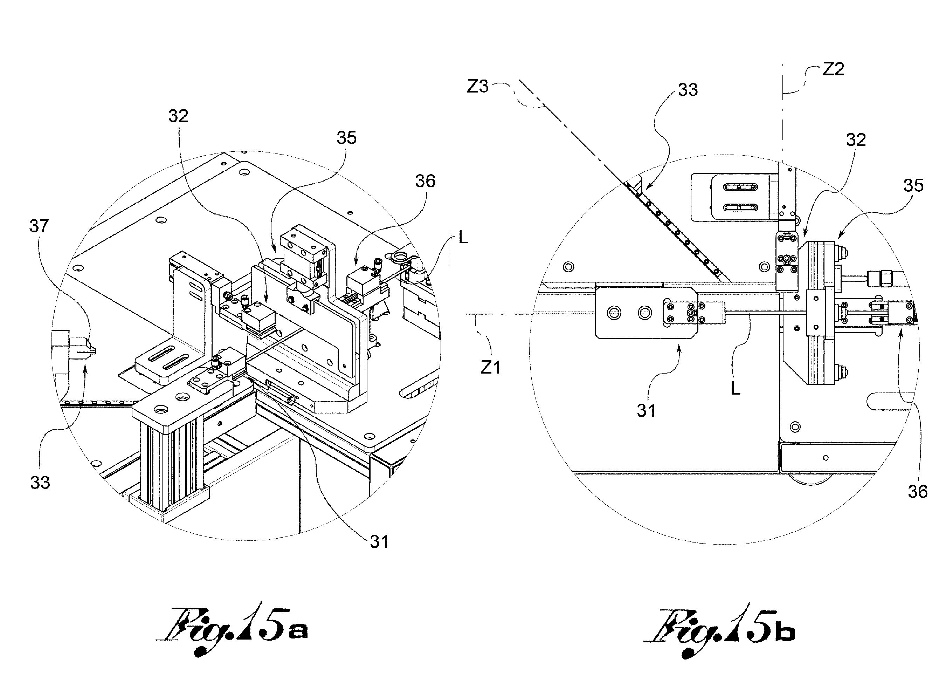

- each pair of figures 15 a-b, 16 a-b, 17 a-b, 18 a-b respectively show a perspective and a corresponding plan view of a detail of the preparation station of a segment of connection line in Figure 14, shown in four different sequential operating steps.

### Detailed description

With reference to the appended drawings, reference numeral 1 globally denotes a system for realising connection lines between strings of cells in photovoltaic modules M according to the invention.

The connection lines are composed of conductor foils L (in particular foils in tinned copper) welded to the electric terminals T of the strings S of a photovoltaic module M according to predefined electric schemes.

According to a general embodiment of the invention, the system 1 comprises:

- at least one support platform 2 for at least one photovoltaic module M in construction having the electric terminals T of the strings S bare;

- at least one device 10 for positioning at least one conductor foil L near the aforesaid platform 2 at one or more preselected terminals T;

- at least one device 20 for welding the aforesaid conductor foil L to the aforesaid one or more preselected electric terminals T.

The positioning device 10 comprising one or more releasable gripping elements 11 of the aforesaid foil L.

Preferably, as illustrated in the appended drawings, such gripping elements 11 consist of pneumatically operable, suction-cup means.

Advantageously, the conductor foils may be supplied to the positioning device in various ways. Preferably, the loading of the foil on the positioning device is automised. The system 1 according to the invention may for such purpose be provided with a magazine of foils ready to use (of predefined shape and dimension) or, as will be explained further below, of a dedicated cutting or cutting and shaping station of the foils, from which the positioning device supplies itself directly.

As will be explained further below, in particular, a conductor foil ready to use may generally be rectilinear or bent (for example at 90°).

Preferably, the loading of the foil on the positioning device 10 is performed by means of the aforesaid gripping elements 11 which the device 10 is provided with.

In the continuation, for simplicity of description, reference will be made to a particular embodiment in which the system is provided with a single positioning device 10 and single welding device 20. This should not be understood as a limitation. Advantageously, embodiments may in fact be envisaged in which the system 1 is provided with two or more positioning devices 10 and two or more welding devices.

In particular, a system 1 may envisaged provided with two positioning devices 10 and two welding devices 20, operating in pairs. A first pair (a positioning device and a welding device) is used for realising the connection lines of a first end of the module M and second pair for the realisation of the connection lines of the second end. The movements of the devices are thereby rationalised and simplified.

According to the invention, the aforesaid at least one positioning device 10 comprises at least one screening plate for welding 12 positioned near the aforesaid gripping elements 11.

In particular, the screening plate 12 is made in thermally insulating and resistant material, such as for example epoxy glass or bakelite.

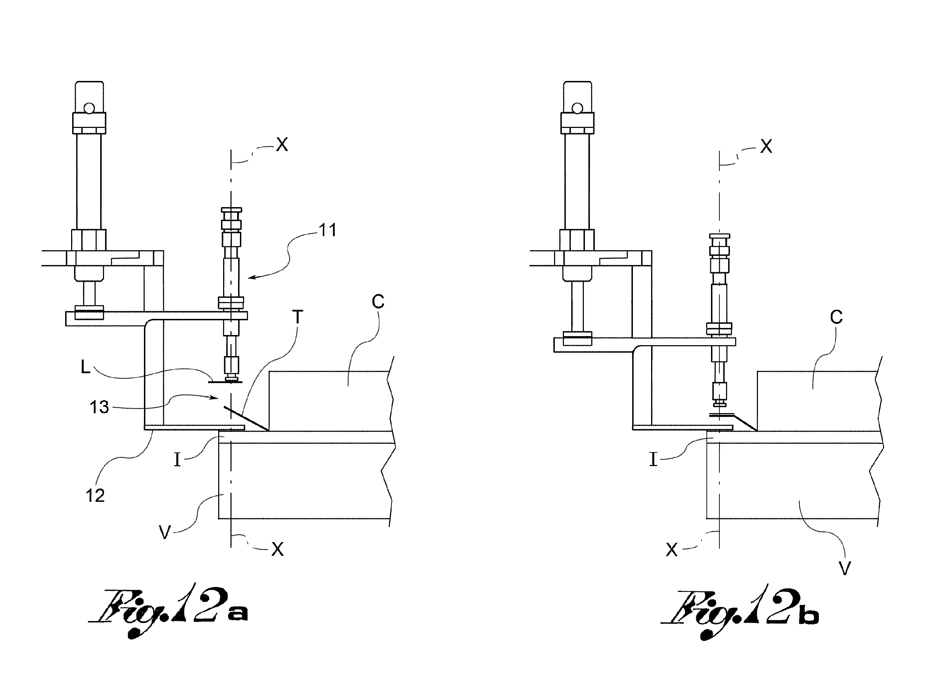

As may be seen in Figures 12a and 12b, the screening plate 12 and the gripping elements 11 are movable in relation to each other between a first position, in which the plate and the gripping elements are distanced from each other to create an aperture 13 for the insertion of the preselected electric terminals T (see Figure 12a), and a second position, in which the plate and the gripping elements are brought closer together so as to reduce the opening of such aperture 13 and allow contact of the foil L,releasably associated with the gripping elements 11, with one or more electric terminals T inserted in such aperture 13 (see Figure 12b).

In Figures 12 a and b, V schematically indicates the glass panel, I the polymeric layer of protective gluing material (such as EVA) and C a cell of a string. As already said, for illustrative purposes the proportions of the parts have not been observed. The Drawings show, even if schematically, the insertion of the terminal T in the aperture 13 existing between the plate 12 and the lower (grip) end of the gripping elements 11.

In other words, according to the invention, the screening plate 12 is mechanically and structurally integral with the gripping elements 11. This considerably simplifies co-ordination of the movements of the screening plate and the gripping elements (with associated ribbon to be welded). In fact the screening plate follows the movements of the gripping elements in a mechanically simple manner. The movement of the gripping elements automatically determines the movement of the plate and its correct positioning in the welding zone.

Thanks to the relative movement between the plate and gripping elements, the screening plate may, in addition, co-operate with such gripping elements to correctly position between them the foil and the terminal elements. The direct kinematic connection between the plate and the gripping elements described above considerably simplifies the operation of the plate in positioning the foil and the electric terminals and its control.

Thanks to the invention, the screening plate is thereby always correctly positioned in relation to the position of the conductor foil, both during the positioning of the latter and during welding.

Advantageously, the positioning device 10 comprises at least one positioning head 101, 102, 103, 104 to which the screening plate 12 is rigidly attached and to which one or more of the aforesaid gripping elements 11 are movably associated by means of one or more actuators 14.

A configuration may also be envisaged in which the screening plate 12 is mobile and the gripping elements 11 are, on the contrary, rigidly attached to the positioning head.

Alternatively, a configuration may also be envisaged in which both the screening plate and the gripping elements 11 are mobile in relation to the positioning head.

The positioning device 10 further comprises means 110 for moving the aforesaid at least one positioning head 101,102,103,104 in relation to the support platform 2 and therefore in relation to the photovoltaic module M placed on it.

As illustrated in the appended Drawings, preferably, the aforesaid means 110 of moving the positioning head 101,102,103,104 consist of an automatic manipulator arm.

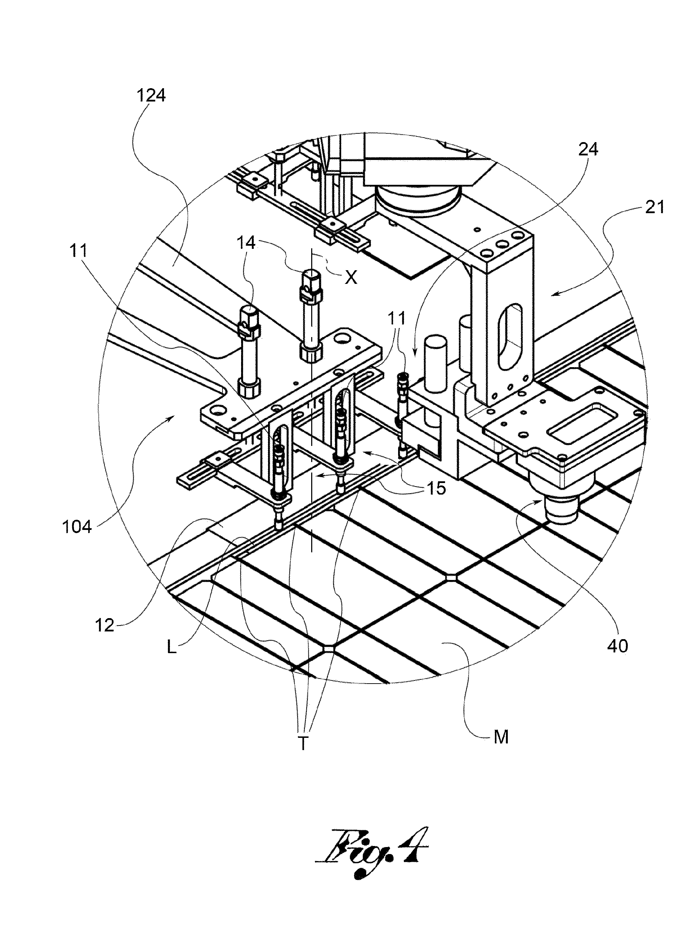

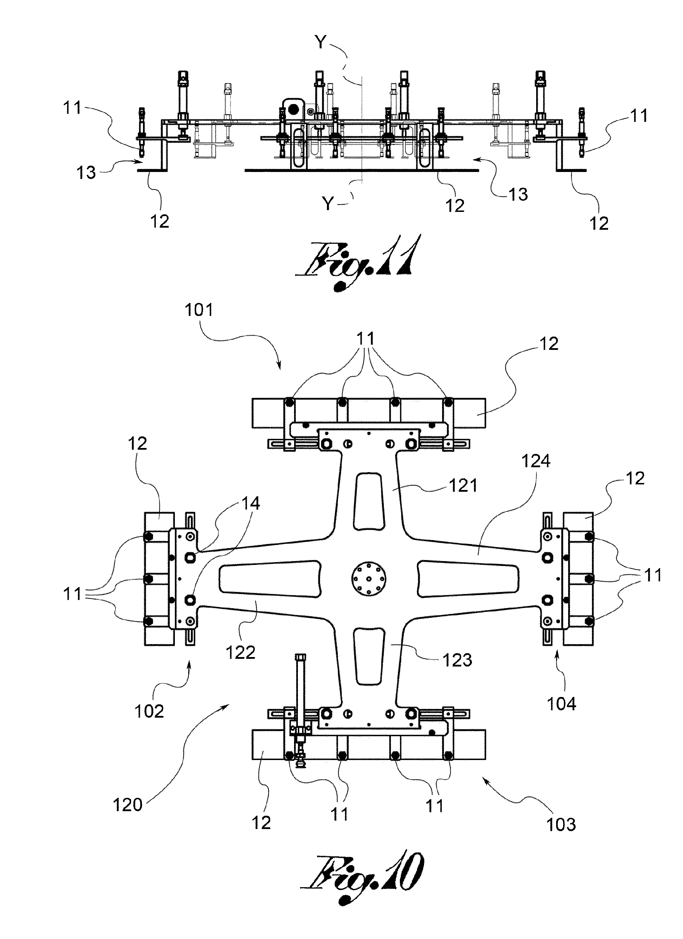

Advantageously, as illustrated in particular in Figures 4, 10 and 11, the screening plate 12 and the gripping elements 11 are connected to overhang the positioning head 101, 102, 103, 104, so as to project in relation to it and in such a way as to be spatially overlapped with each other along a relative direction of movement X.

Advantageously, as illustrated for example in Figure 4, the positioning head 101, 102, 103, 104 comprises two or more gripping elements 11 distanced from each other so as to define one or more insertion seats 15 of the aforesaid welding device 20. To such purpose, as will be explained further below, the welding device 20 may be specially configured.

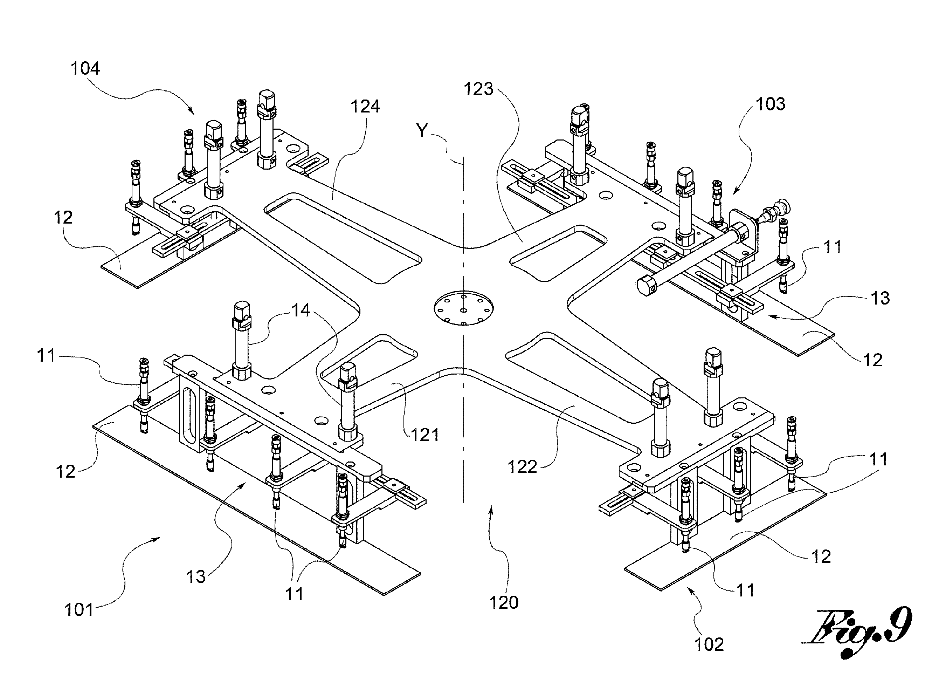

According to a preferred embodiment illustrated in particular in Figures 9, 10 and 11, the positioning device 10 comprises two or more positioning heads 101, 102, 103, 104 spatially distanced from each other. Each positioning head is provided with a screening plate 12 and with one or more gripping elements 11 of a conductor foil L. This way more than one foil can be loaded on the positioning device, in a number corresponding at least to the number of positioning heads. This speeds up the positioning operations. In fact the positioning device thereby avoids having to perform the movement from the foil loading zone to the support platform of the module under construction for each foil.

According to an embodiment illustrated in particular in Figures 9, 10 and 11, the positioning device 10 comprises a support structure 120, provided with several arms 121, 122, 123, 124 which extend in different radial directions starting from a common rotation axis Y. Each arm bearing at its end one of the aforesaid positioning heads 101, 102, 103, 104.

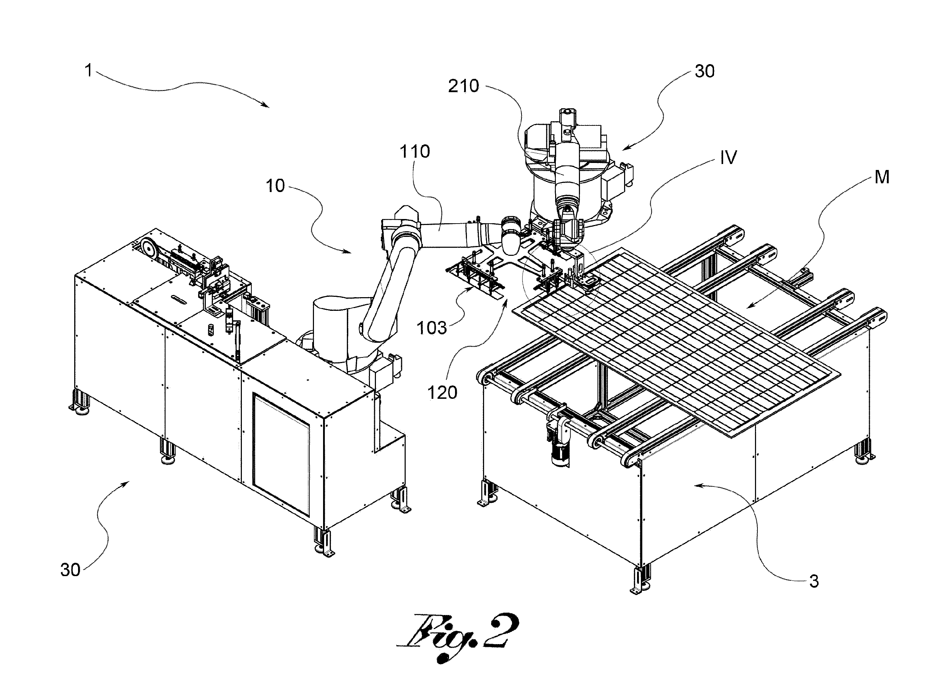

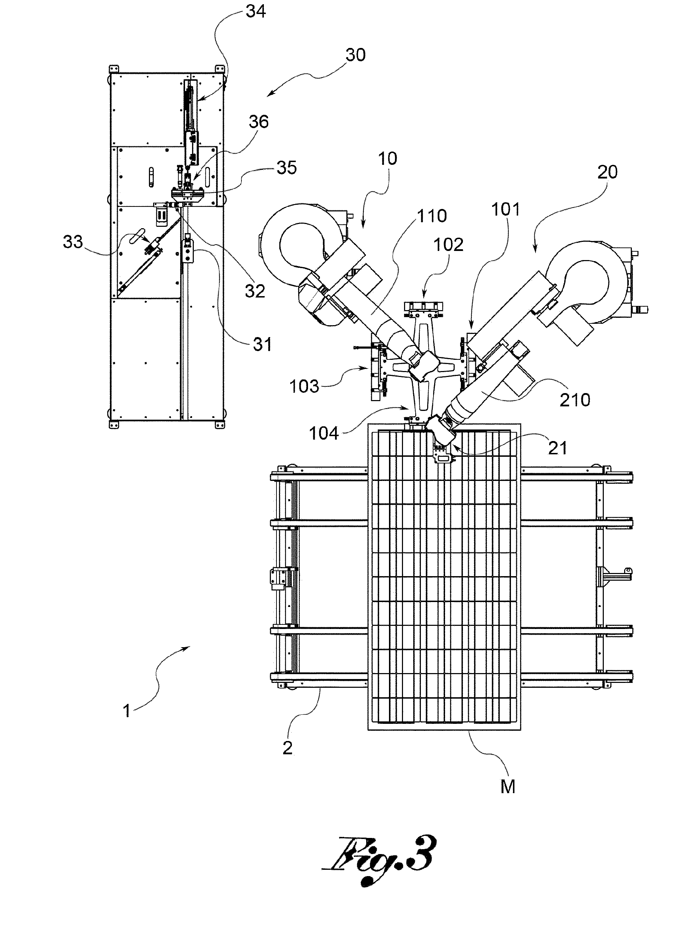

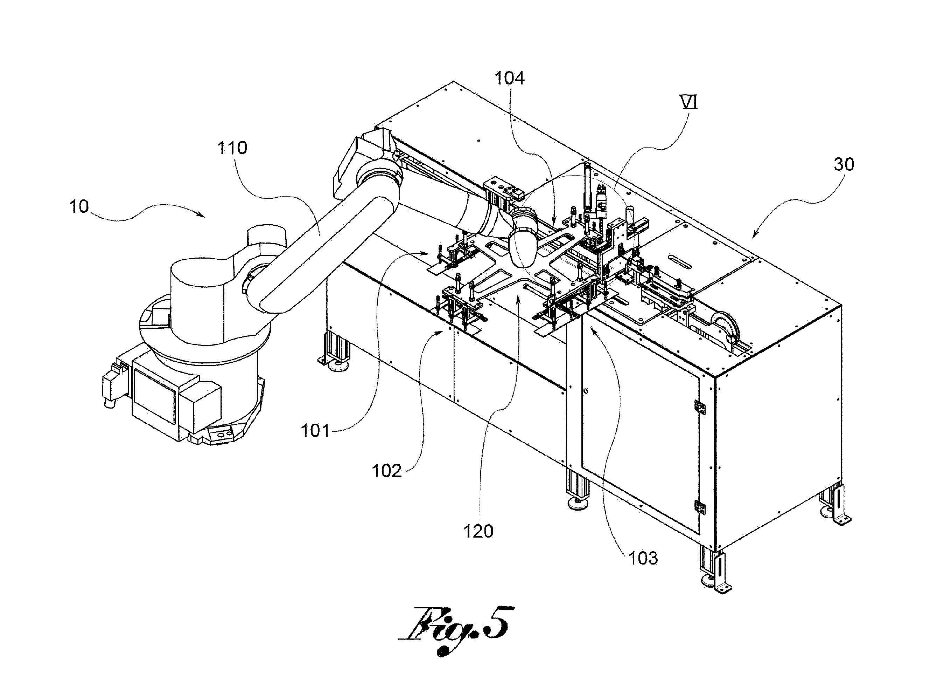

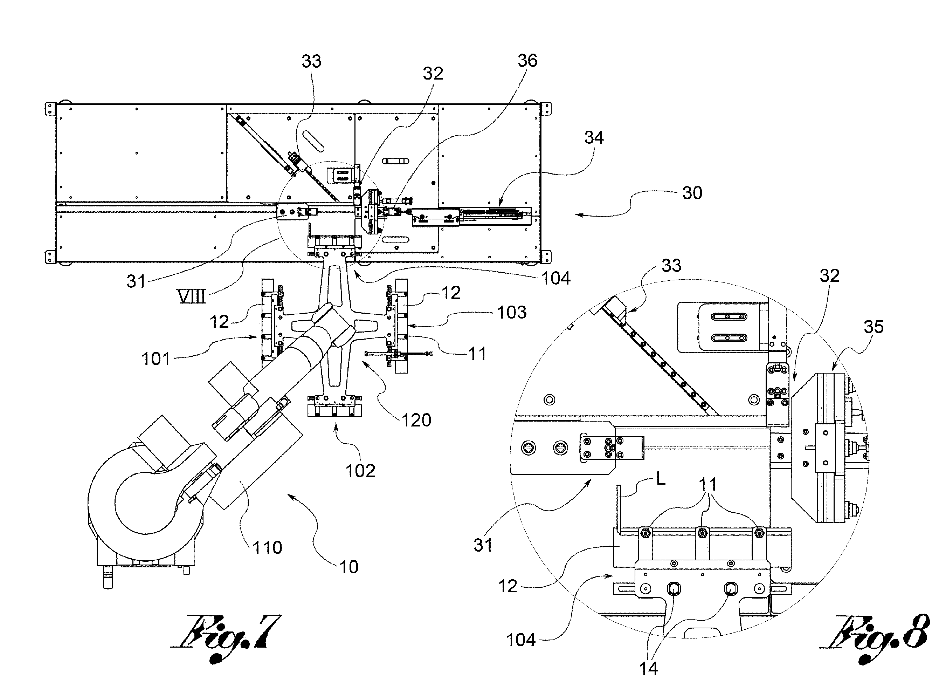

As illustrated in Figures 5 and 7, the support structure 120 is rotationally connected to the moving means 110 ( in particular the manipulator arm) in relation to the aforesaid rotation axis Y. Operatively, with controlled rotations of the support structure 120 all the positioning heads 101, 102, 103, 104 are sequentially brought to interact with the foil loading zone (as illustrated for example in Figures 5 and 7) or to operate on the module placed on the support platform (see Figures 2 and 3).

Advantageously, the welding device 20 comprises at least one welding head 21 and means 210 for moving said welding head 21 in relation to the support platform 2 and to the photovoltaic module under construction placed on it.

As illustrated in the appended Drawings, preferably, the aforesaid means 210 of moving the welding head 21 consist of an automatic manipulator arm. Different means of movement may also be envisaged, consisting for example of first guide elements parallel to one side of the platform (along which an end of the module with bare terminals is positioned) and second guide elements orthogonal to the first to move the welding head at least in two dimensions.

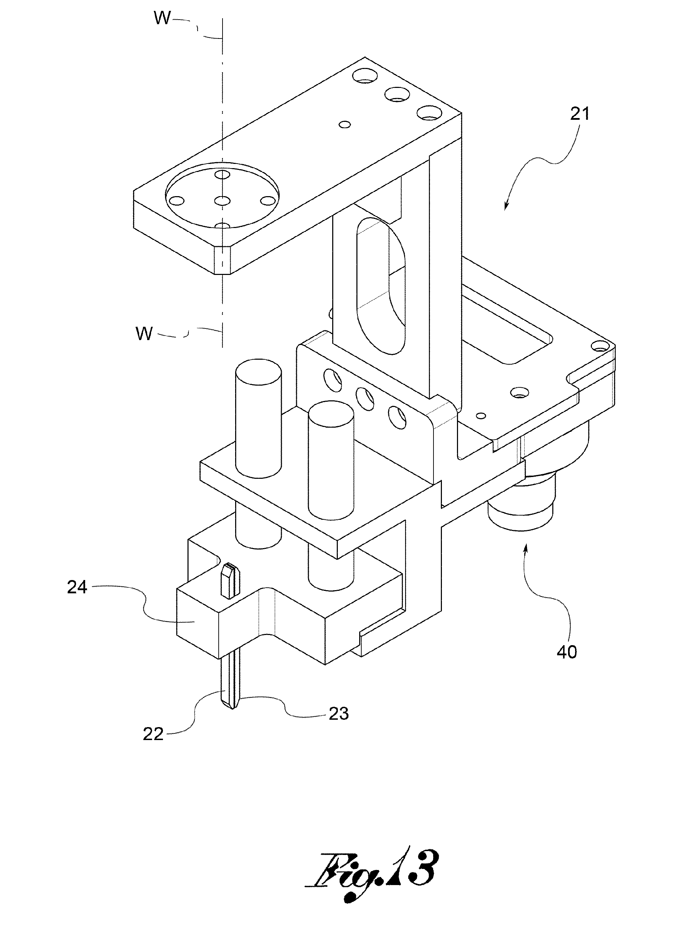

Preferably, as illustrated in particular in Figures 4 and 13, the welding head 21 is of the through current type, i.e. of the stapler type. It is provided with two electrodes 22, 23 destined to contact the conductor foil L in the points of welding with the electric terminals T. The use of this welding technology makes it possible to considerably reduce operating times compared to tinning or the induction welding method or to reduce costs compared to the laser welding technique. Compared to all the aforesaid methods a complete welding of the foil to the electric terminal is achieved, creating a single body of the copper cores. Diversely from the three methods mentioned above, which substantially determine welding only between the tin coatings, the use of the through current welding method makes it possible to avoid the so-called "cold welding". This considerably improves the functioning efficiency of the final photovoltaic module.

As may be seen in particular in Figures 4 and 13, the aforesaid two electrodes 22, 23 are supported by a projecting appendage 24 having a shape corresponding to the aforementioned insertion seats 15 (defined by the space existing between the individual gripping elements 11) so as to make a coupling possible between the welding head 20 and a positioning head 101, 102, 103, 104 and thereby the correct positioning of the electrodes 22, 23 in relation to the foils L to be welded.

Advantageously, the system 1 is provided with means 40 for detecting the number and position of the terminals and therefore the welding points of the foils. In particular such detection means 40 may be of the optical type or laser. Such detection means 40 are connected to a control device of the system and provide the information needed to control and guide the positioning and welding devices depending on the number and position of the welds to be performed. Operatively, before proceeding with positioning of the foils and welding of the same to the terminal, the welding zones ( i.e. the areas where the terminals T are positioned) are scanned with the aforesaid detection means 40 so as to identify the number and position of the terminals T and therefore establish the dimensions and shape of the foils to be used, as well as the welding points.

According to an embodiment illustrated in particular in the appended drawings, and in particular in Figures 4 and 13, such detection means 40 consist of a telecamera associated to the welding head 21 of the welding device 20. The welding head 21 is rotationally connected around a rotation axis W to the moving means 210 so that the electrodes 22, 23 or the telecamera 40 can alternatively be directed at the welding area.

Alternatively, the detection means may be associated to the positioning device 10 or be supported by movement means dedicated to such purpose.

As already mentioned earlier, the system 1 according to the invention may be provided with a cutting and shaping station of the foils, from which the positioning device 10 supplies itself directly, taking the foils of the desired dimensions and shape.

According to a preferred embodiment, the system comprises at least one device 30 for cutting and shaping conductor foils L starting directly from coil wound material.

More in detail, as illustrated in particular in Figures 5 and 7 and from 14 to 18, such cutting and shaping device 30 comprises:

- at least one unwinder element 34 for a coil of conductor foil;

- a first mobile grasping element 31 suitable for dragging the free end of the foil L wound in a coil along a longitudinal direction of unwinding Z1;

- means for cutting 35, ( such as a shears or guillotine blade) positioned transversally to the unwinding direction Z1 to cut a segment L1 of the foil L having a length defined substantially by the movement of the first mobile grasping element 31 along said unwinding direction Z1;

- a second grasping element 32 movable along a direction Z2 transversal (preferably orthogonal) to the unwinding direction Z1 and suitable to support the foil L downstream of the cutting means 35.

Preferably, the cutting and shaping device 30 comprises a blocking element 36 (such as a press) of the foil L, upstream of the cutting means 35. Such blocking element 36 is used to retain the foil after cutting to prevent the free end from disengaging the cutting means, for example, as a result of being dragged away by the winding rotation of the coil.

Preferably, the cutting and shaping device 30 comprises a third grasping element 33 , movable along a direction Z3 set at an angle to the unwinding direction Z1 and susceptible to grasp the foil L downstream of the second mobile grasping element 32. Such third grasping element 33 is provided with a rotating gripping head 37. Operatively the rotation of the head 37 impresses on the foil L a bend in the point of grasping.

In particular, in the case in which a bend of 90° of the foil is desired, a preferred configuration envisages that the third grasping element 33 is movable along a direction Z3 angled at about 45° to the unwinding direction Z1 and that the rotating head 37 rotates by 180°.

Advantageously, the first 31 and the second 32 mobile grasping elements consist of pliers, provided with operating means. The third grasping element 33 need not be a plier but may be a mere fork.

The bending of a foil L with a 90°bend is briefly described below with reference to figures 15 to 18.

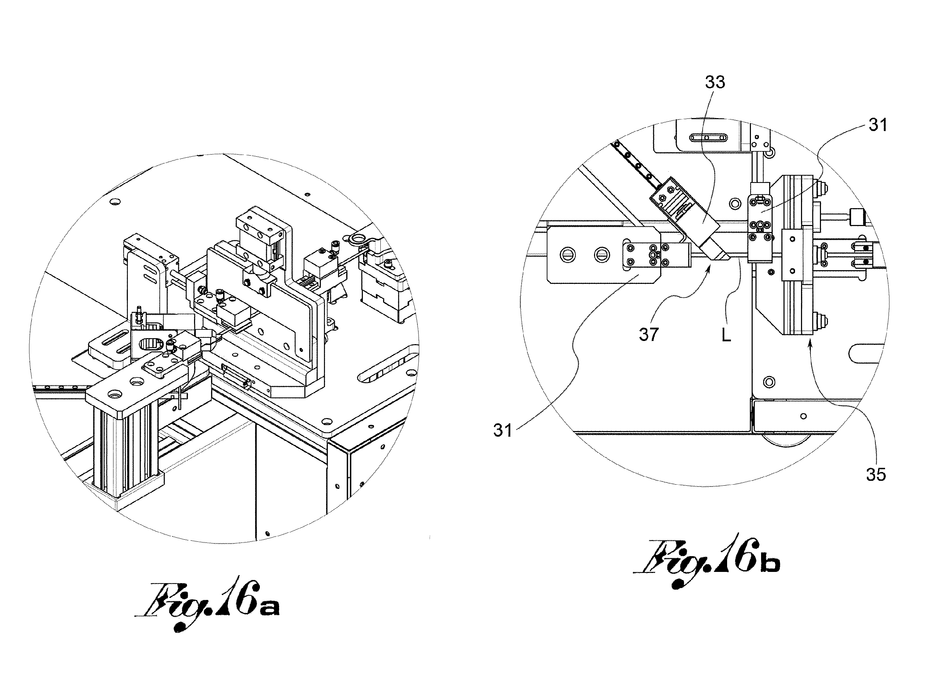

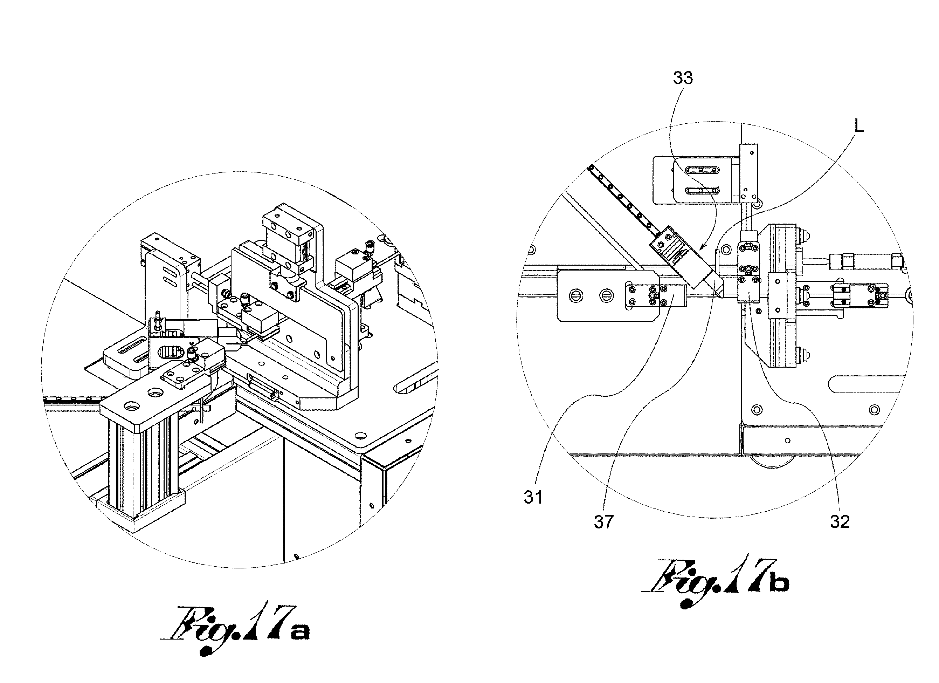

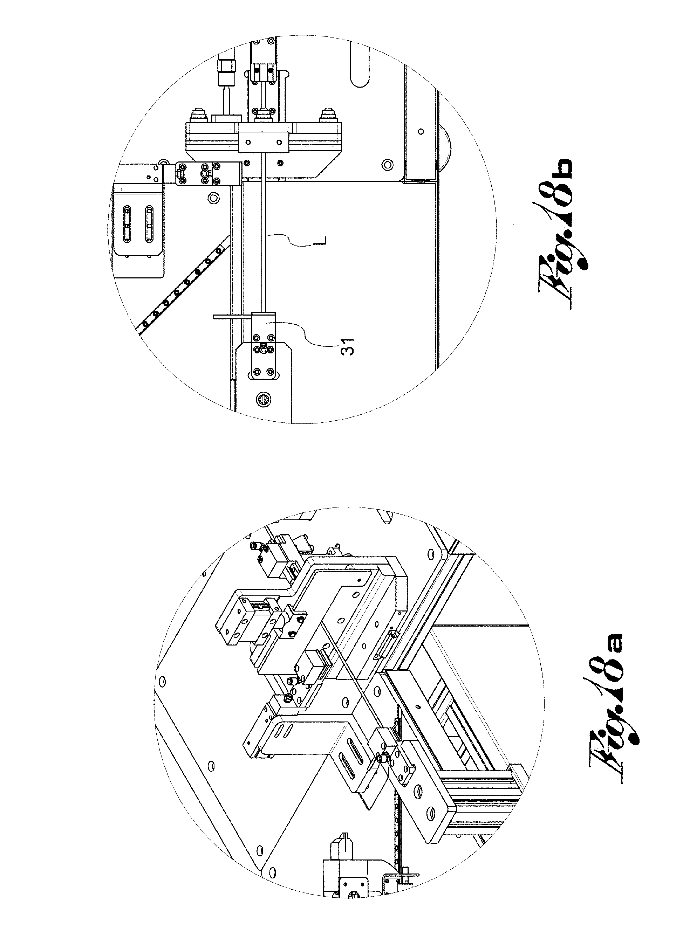

The first mobile grasping element 31 grasps the end of the foil L near the cutting means 35. The blocking element 36 (formerly closed) is opened. The first mobile grasping element 31 drags the foil in the direction Z1 for a defined distance (figures 15a-b). The second mobile element moves forward and grasps the foil, supporting it. The third grasping element grasps the section of unwound foil in an intermediate position between the first 1 and the second mobile element 32 (figures 16a-b). The first grasping element 31 releases the grip and moves rearward for a distance sufficient to leave the end of the foil entirely free. The rotating head 37 of the third element 33 rotates by 180° so as to bend the foil (figures 17a-b). The third grasping element 33 moves rearward leaving the bent foil free, supported by the second mobile element 32. The first grasping element 31 now moves forward as far as to grasp the foil at the point of the bend. The plier of the first mobile element 31 is operated to flatten the bend. The second mobile element 32 moves rearward freeing the foil. The first element 31 can now moves rearward dragging the foil for predefined distance depending on the length which the second section of the foil is to have (figures 18a-b). The second mobile element 32 moves forward again to grasp the foil and support it. The blocking element 36 is then closed again and the cutting means activated. The bent foil L is supported by the first and by the second mobile element. At this point as illustrated in Figures 7 and 8, the positioning device 10, with one of the positioning heads 124 can take the foil activating the gripping (suction-cup) elements it is provided with.

In the event that a foil of a linear form is required, it is sufficient not to use the third mobile grasping element.

The cutting and shaping device 30 described above makes it possible to render the system 1 according to the invention independent, given that it permits the realisation to order of foils having the desired dimensions and forms, as required by the module being processed.

Advantageously, the cutting and shaping device 30 may be used independently of the system 1 according to the invention as described above. In other words, as illustrated in Figure 14, the device 30 can be used as an element in itself, without necessarily being associated with the platform 2, the positioning device 10 and the welding device 20 as described above.

The invention makes it possible to achieve numerous advantages, in part already described.

The system for realising connection lines between strings of cells in photovoltaic modules makes it possible to position both the protective screening plate and the connection ribbons in an operatively simpler and efficient manner. In particular, the movement of such parts is automatically co-ordinated and does not require additional checking of the position other than that needed for positioning the foils in the required position.

The system 1 for realising connection lines in photovoltaic modules is, in addition mechanically reliable, with particular reference to the foil positioning device.

The system 1 according to the invention makes it possible to reduce processing times making the realisation of connection lines ( i.e. the "bussing") of the strings of cells in photovoltaic modules more efficient and faster. From this point of view the use of the through current welding method is particularly important in that it considerably reduces operating times during the welding step.

Compared to similar systems of the prior art, the system 1 is, furthermore, easy and economical to realise given that it does not require separate means of positioning of the screening plate and the foil.

The invention thus conceived thereby achieves the intended purposes.

Obviously, its practical embodiments may assume forms and configurations different from those described while remaining within the scope of protection of the invention.

In addition, all the elements may be replaced with technically equivalent elements and the dimensions, shapes and material used may be varied as needed.

## Claims

1. System for realising connection lines between strings of cells in photovoltaic modules, said connection lines being composed of conductor foils (L) welded to electric terminals (T) of the strings (S) of a photovoltaic module (M) according to predefined electric schemes, said system (1) comprising:
- a support platform (2) for at least one photovoltaic module (M) in construction having the electric terminals (T) of the strings (S) bare:
- at least one device (10) for positioning at least one conductor foil (L) near said platform (2) at one or more preselected terminals (T), said positioning device (10) comprising one or more releasable gripping elements (11) of said foil (L);
- at least one device (20) for welding said conductor foil (L) to said one or more preselected electric terminals (T),
**characterised by** the fact that said at least one positioning device (10) comprises at least one screening plate for welding (12) positioned near said gripping elements (11), said screening plate and said gripping elements being movable in relation to each other between a first position, wherein said plate (12) and said gripping elements (11) are distanced from each other to create an aperture(13) for the insertion of said preselected electric terminals (T), and a second position, wherein said plate and said gripping elements are brought closer together so as to reduce the opening of such aperture (13) and allow contact of said foil (L), releasably associated with the gripping elements (11), with one or more electric terminals (T) inserted in such aperture (13).

2. System according to claim 1, wherein said at least one positioning device (10) comprises:
- at least one positioning head (101, 102, 103, 104) to which the screening plate (12) is rigidly attached and said one or more gripping elements (11) are movably associated by means of one or more actuators (14), and vice versa;
- means (110) for moving said at least one positioning head (101, 102, 103, 104) in relation to said support platform (2).

3. System according to claim 2, wherein said screening plate (12) and said one or more gripping elements (11) are connected to said at least one positioning head (101, 102, 103, 104) so as to project in relation to it and be spatially overlapped with each other along at least one relative direction of movement (X).

4. System according to claim 2 or 3, wherein said at least one positioning head (101, 102, 103, 104) comprises two or more gripping elements (11) distanced from each other so as to define one or more insertion seats (15) for said welding device (20).

5. System according to one or more of the claims from 2 to 4, wherein said at least one positioning device (10) comprises two or more positioning heads (101, 102, 103, 104) spatially distanced from each other, each positioning head being provided with one screening plate (12) and one or more gripping elements (11) for a conductor foil (L).

6. System according to claim 5, wherein said positioning device (10) comprises a support structure (120), provided with arms (121, 122, 123, 124) which extend in different radial directions starting from a common rotation axis (Y), each arm bearing at its end one of said positioning heads (101, 102, 103, 104).

7. System according to claim 6, wherein said support structure (120) is rotationally connected to said moving means (110) in relation to said rotation axis (Y).

8. System according to one or more of the claims from 2 to 7, wherein said moving means (110) consist of an automatic manipulator arm.

9. System according to one or more of the previous claims, wherein said at least one welding device (20) comprises a welding head (21) and means (210) for moving said welding head (21) in relation to said support platform (2), said welding head (21) being of the through current type and being provided with two electrodes (22, 23) destined to contact said conductor foil (L) in the points of welding with the electric terminals (T).

10. System according to claims 4 and 9, wherein said two electrodes (22, 23) are supported by a projecting appendage (24) having a shape corresponding to said insertion seats (15) so as to make a coupling possible between said welding head (20) and a positioning head (101, 102, 103, 104).

11. System according to one or more of the previous claims, comprising at least one device (30) for cutting and shaping conductor foils (L) starting directly from coil wound material, comprising:
- at least one unwinder element (34) for a coil of conductor foil;
- a first mobile grasping element (31) suitable for dragging the free end of said foil (L) wound in a coil along a longitudinal direction of unwinding (Z1);
- means for cutting (35), positioned transversally to said unwinding direction (Z1) for cutting a segment (L1) of said foil (L) having a length defined substantially by the movement of said first mobile grasping element (31) along said unwinding direction (Z1);
- a second grasping element (32) movable along a direction (Z2) transversal to said unwinding direction (Z1) and suitable to support said foil (L) downstream of the cutting means (35).

12. System according to claim 11, wherein the cutting and shaping device (30) comprises a blocking element (36) of said foil (L) upstream of said cutting means (35).

13. System according to claim 11 or 12, wherein the cutting and shaping device (30) comprises a third grasping element (33), movable along a direction (Z3) set at an angle to said unwinding direction (Z1) and susceptible to grasp said foil (L) downstream of said second mobile grasping element (32), said third grasping element (33) being provided with a rotating gripping head (37), the rotation of said head (37) impressing on said foil (L) a bend in the point of grasping.
